# EUROPEAN PATENT SPECIFICATION

(11) **EP 3 596 411 B1**
(45) Date of publication and mention of the grant of the patent: **27.12.2023**
(21) Application number: 18715312.7
(22) Date of filing: 12.03.2018
(51) Int. Cl.: F25B 49/00

(54) **FAULT DETECTING SYSTEM AND METHOD FOR REFRIGERATION SYSTEM AND REFRIGERATION SYSTEM**
FEHLERDETEKTIONSSYSTEM UND -VERFAHREN FÜR KÜHLSYSTEM SOWIE KÜHLSYSTEM
SYSTÈME ET PROCÉDÉ DE DÉTECTION DE DÉFAUT POUR SYSTÈME DE RÉFRIGÉRATION ET SYSTÈME DE RÉFRIGÉRATION

(30) Priority: 16.03.2017 CN 201710156146
(43) Date of publication of application: 22.01.2020
(73) Proprietor: Carrier Corporation, Jupiter, FL 33478 (US)
(72) Inventor: CHEN, Linhui, Shanghai 201206 (CN); XIE, Kangshan, Shanghai 201206 (CN)
(74) Representative: Dehns
(86) International application number: PCT/US2018/021970
(87) International publication number: WO 2018/169849

(56) References cited:
- EP-A1- 2 738 495
- DE-A1-102012 008 926
- US-A- 5 512 883
- US-A1- 2016 290 671

## Description

The present invention relates to the technical field of refrigeration systems and more specifically, the present invention relates to a fault detection method for a refrigeration system, claimed in claim 1 and a refrigeration system, especially a transport refrigeration system, claimed in claim 11.

In the design of an existing refrigeration system, especially a transport refrigeration system, a large-power device such as a condenser fan motor or an evaporator fan motor is directly connected to a power source. A controller controls each large-power device by means of a control unit such as an external relay, to prevent the large-power device from enduring a large current. The controller cannot monitor a working state of the large-power device as the controller is not connected to a power supply circuit between the power source and the large-power device. As such, a user cannot know a fault in time when it occurs, and as a result, the temperature of a refrigerator is out of control or a unit runs in an abnormal condition for a long time, thus reducing the reliability of the system.

DE 102012008926 discloses a refrigeration system comprising a device control and one or more devices, wherein the device control is connected to one or more devices and is configured to check current or power consumption by a subset of the devices or by the device control itself.

An objective of at least the preferred embodiments of the present invention is to provide a fault detection method for a refrigeration system, so as to detect a fault of a large-power device in the refrigeration system timely and accurately.

Another objective of at least the preferred embodiments of the present invention is to provide a refrigeration system, especially a transport refrigeration system in which a fault of a large-power device can be detected timely and accurately.

Another objective at least the preferred embodiments of of the present invention is to solve or at least alleviate the problems in the prior art.

According to an aspect of the present invention, a fault detection method for a refrigeration system is provided, including:
an initial detection step, wherein the initial detection step comprises: acquiring an output current or output power of a power source when system parameters are stable; and when the system parameters are unstable, re-determining whether the system parameters are stable after a delay of first predetermined time; calculating a theoretical output current or output power of the power source; and comparing the output current or output power of the power source with the theoretical output current or output power of the power source to determine whether an anomaly exists in the system; and marking a system anomaly if an anomaly exists in the system; and
a fine detection step, wherein the fine detection step comprises determining whether there is a system anomaly mark, wherein if there is no system anomaly mark, the method returns to the initial detection step; re-determining whether the system parameters are stable, wherein if the system parameters are unstable the fine detection step is started again after a delay of a certain time; and changing a working state of at least one device, and comparing the output currents or output powers of the power source before and after the working state of the at least one device is changed, so as to determine whether an anomaly exists in the at least one device.

According to another aspect of the present invention, a refrigeration system is provided, in which the method according to the embodiment of the present invention is applied.

The disclosure of the present invention will be more comprehensible with reference to the accompanying drawings. It can be easily understood by those skilled in the art that these accompanying drawings are merely used for illustration, and are not intended to limit the protection scope of the present invention. Moreover, similar numerals in the drawings are used for denoting similar components, wherein:
FIG. 1 is a schematic circuit diagram of a refrigeration system having a fault detection system;
FIG. 2 shows a basic process of a fault detection method for a refrigeration system;
FIG. 3 shows an initial detection process of a fault detection method for a refrigeration system;
FIG. 4 shows a part of a fine detection process of a fault detection method for a refrigeration system; and
FIG. 5 shows the other part of the fine detection process of the fault detection method for a refrigeration system.

It is easily understood that those of ordinary skill in the art can propose various other structure manners and implementation manners, which are interchangeable, according to the technical solution of the present invention without departing from the essential spirit of the present invention. Therefore, the following specific implementation manners and the accompanying drawings are merely exemplary description about the technical solution of the present invention, and should not be considered as all of the present invention, or as constraints or limitations to the technical solution of the present invention, which is defined in the claims.

Orientation terms, such as upper, lower, left, right, before, after, front, back, top, and bottom, that are mentioned or may be mentioned in the specification are defined relative to the structures shown in the accompanying drawings. The terms are relative concepts, and thus may correspondingly change according to their different positions and different use states. Therefore, these or other orientation terms should not be interpreted as limitative terms, either.

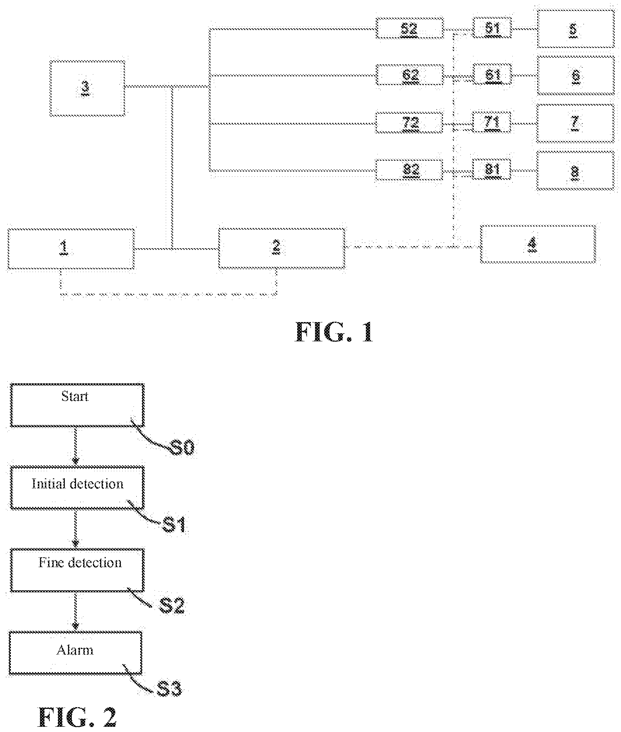

Referring to FIG. 1, a schematic circuit diagram of a refrigeration system having a fault detection system according to an embodiment of the present invention is shown. The refrigeration system according to the embodiment of the present invention basically includes a power source 1, a controller 2, a battery 3, components 4, and a plurality of devices connected in parallel, including a first device 5, a second device 6, a third device 7, and a fourth device 8. These devices 5, 6, 7, and 8 can be large-power devices, such as condenser fan motors or evaporator fan motors. In some embodiments, the power source 1 can be a DC or AC generator of a transport vehicle that supplies power to a refrigeration system. In an electromobile or another embodiment, the power source 1 can be a power battery for powering a refrigeration system and a transformer device of the power battery. In this embodiment, the first device 5 and the second device 6 are condenser fan motors, and the third device 7 and the fourth device 8 are evaporator fan motors. As large currents exist in branches of the devices, fuse protection apparatuses include a first fuse protection apparatus 52, a second fuse protection apparatus 62, a third fuse protection apparatus 72, and a fourth fuse protection apparatus 82 that are provided on the branches. Control units for the devices 5, 6, 7, and 8 are further disposed on the branches of the devices, including a first control unit 51, a second control unit 61, a third control unit 71, and a fourth control unit 81. A controller 2 is in control connections with the control units. In some embodiments, one or more of the control units can be relays, and the controller 2 can control on/off of the devices by using the relays. In some embodiments, one or more of the control units can be high and low-speed control lines, and the controller can selectively conduct the high and low-speed control lines to enable the fan motors to run at different rotational speeds. In some embodiments, one or more of the control units can be control circuit boards, and the controller can control rotational speeds of the fan motors by using the control circuit boards. The power source 1 is electrically connected to the devices 5, 6, 7, and 8, so as to form a power supply loop to supply power to the devices. Optionally, the power source 1 is further electrically connected to the controller 2, so as to supply power to the controller 2. The battery 3 is electrically connected to the power source 1 and provides power required during starting of the system and stores power during normal operation of the system. The controller 2 can obtain an output current or output power of the power source 1. In some embodiments, the controller 2 communicates with the power source 1, for example, communicates with the power source 1 via an LIN network to acquire the output current or output power of the power source 1 in real time. An excitation current of the power source 1 can be acquired, and the output current or output power of the power source 1 can be reckoned based on an experimental datafitting relational expression between the excitation current and the output current or output power. The controller 2 is further in control connections with the components 4 in the refrigeration system to control the components 4. The components 4 can include various valves in the system, and the like. The controller 2 is further in control connections with the control units 51, 61, 71, and 81 of the devices, so as to control the devices. As large currents exist in the branches of the devices, the controller 2 is not directly connected to the branches. As such, although the controller 2 sends control instructions to the control units, the controller 2 cannot directly acquire working state feedback of the devices. For example, even if the first fuse protection apparatus 52 is fused, the controller 2 cannot directly know that the first device 5 stops working. In order to detect such faults, the controller 2 performs the steps described in detail in the following.

Referring to FIG. 2, a detection method performed by the controller 2 substantially includes: step S0, Start detection, step S1, Initial detection, step S2, Fine detection, and step S3, Raise an alarm.

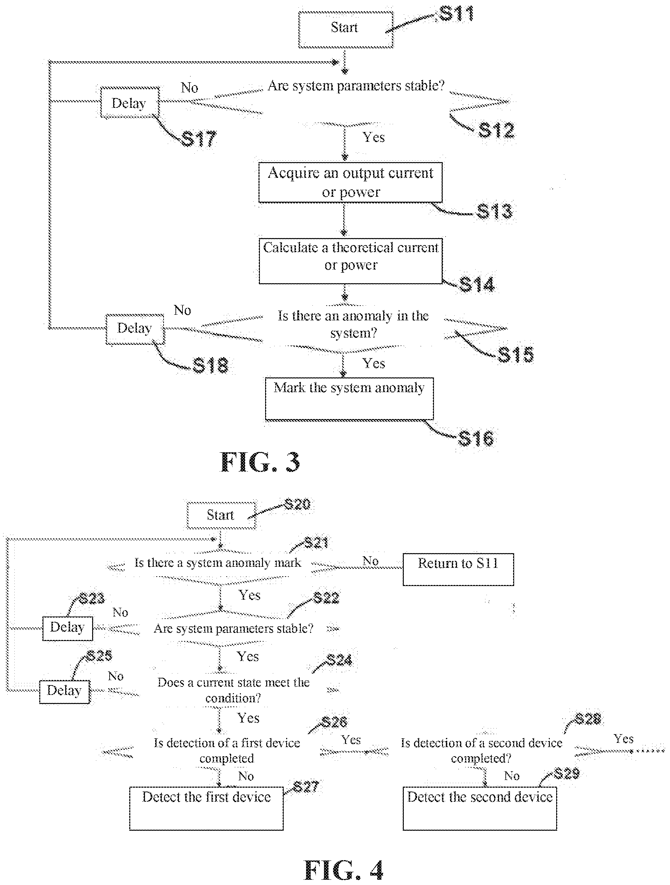

The initial detection step is introduced in detail by further referring to FIG. 3. In the initial detection step, a difference is mainly obtained by comparing an output current or output power of a power source with a theoretical output current or output power of the power source, and it is considered that an abnormal device exists in the system when the difference is dramatic. In some embodiments, the initial detection step of the fault detection method according to the present invention includes: step S 11, Start. In step S12, it is determined whether system parameters are stable. When the refrigeration system is just started or is in an unstable state, the output current or output power of the power source may fluctuate, and therefore, the controller 2 can set some parameters in step S12 to determine whether the system is stable, so as to avoid incorrect diagnosis in the existence of fluctuation. In some embodiments, the controller 2 determines whether the output current or output power is stabilized in a certain interval and lasts for a period of time, for example, determining whether the output current or output power is stabilized within +10% and -10% and lasts for more than 30 seconds, and so on. For another example, the controller 2 determines whether the temperature of the system is kept in a certain interval and lasts for a period of time, and so on. It should be understood that the system parameters are not limited to the above specific embodiment. When the controller 2 determines that the system parameters are unstable, the process proceeds to step S17, in which the determination of step S12 is performed again after a delay of a certain time such as first predetermined time, for example, a delay of 1 minute, and so on. When the controller 2 determines that the system parameters are stable, the process proceeds to step S13, in which the output current or output power of the power source is acquired. The controller 2 can be connected with the power source 1 via the LIN network, acquire an excitation current of the power source 1, and reckon the output current or output power of the power source 1 based on a relation between the excitation current and the output current or output power. Alternatively, the controller 2 can also acquire the output current or output power of the power source 1 in other manners. In step S14, the controller 2 calculates the theoretical output current or output power of the power source according to the working state of the system. The working states of the large-power devices in the system are controlled by control instructions sent by the controller 2, and therefore, the controller 2 can estimate the working states of the devices according to the control instructions, and calculate the theoretical output current or output power of the power source in this state. For example, the controller 2 can control the first device and the third device to operate at a high rotational speed, and control the second device and the fourth device to operate at a low rotational speed; therefore, the controller 2 can calculate the theoretical output current or output power of the power source in this working state, that is, a sum of currents or powers consumed by the devices when the devices work normally in this state. It should be understood that steps S13 and S14 can be performed in a reversed order or performed simultaneously. Subsequently, in step S 15, the output current or output power of the power source is compared with the theoretical output current or output power of the power source to determine whether an anomaly exists in the system. In some embodiments, whether an anomaly exists in the system can be determined based on a difference or ratio between the output current or output power of the power source and the theoretical output current or output power of the power source. By taking a difference as an example, when the difference is greater than a predetermined value, it is considered that there is a device working abnormally in the system, and the process proceeds to step S16 to mark the system anomaly. If the difference is within a predetermined range, it is considered that no anomaly exists in the system, and the process proceeds to step S18, in which after a delay of a certain time such as 1 minute, the process returns to step S12 to perform detection again. In step S15, in addition to determining whether an anomaly exists in the system based on a difference or ratio between the output current or output power of the power source and the theoretical output current or output power of the power source, the output current or output power of the power source and the theoretical output current or output power of the power source can further be processed based on another mathematical method to obtain a reference standard and determine whether an anomaly exists in the system. In addition, it should be understood that marking the system anomaly in step S16 merely means that the system might have an anomaly, rather than that the system definitely has an anomaly. Therefore, an alarm may not be sent to a user in this step.

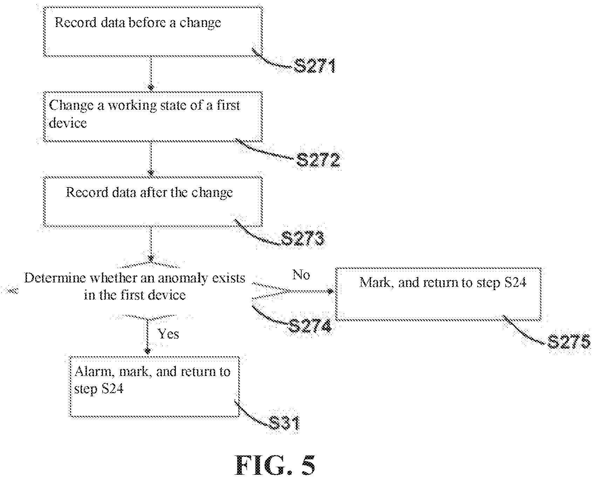

The fine detection step is further illustrated in detail with reference to FIG. 4 and FIG. 5. In the fine detection step shown in FIG. 4, a working state of at least one device is changed, and output currents or output powers of the power source before and after the working state is changed are compared, so as to determine whether an anomaly exists in the at least one device. In some embodiments, the fine detection step includes step S20, Start. In step S21, it is determined whether there is a system anomaly mark, if there is no system anomaly mark, the process returns to step S11 of initial detection to perform initial detection again, and if there is a system anomaly mark, the process proceeds to step S22. In step S22, similar to step S12 of initial detection, it is re-determined whether the system parameters are stable. The system parameters include, but are not limited to, an output current or output power of a power source, control parameters of a controller, a refrigeration system mode, the temperature of the refrigeration system, the temperature of a refrigerator region, and so on. When a selected determination standard parameter keeps stable, the process proceeds to step S24; otherwise, the process proceeds to step S23 in which the fine detection is started again after a delay of a certain time. In step S24, it is determined whether a current state meets a condition of changing a working state of at least one device. For example, assume that the refrigeration system is in a defrosting mode, it is unsuitable to change a working state of a device such as a condenser fan motor and an evaporator fan motor. It should be understood that the objective of the step is to ensure that the detection will not essentially affect the normal operation of the refrigeration system. It should be understood that step S22 and step S24 can be performed in a reversed order or performed simultaneously. Therefore, when the current state does not meet the condition of changing the working state of the device, the process proceeds to step S25, in which the process returns to step S21 after a delay of second predetermined time such as 1 minute. If the current state meets the condition of changing the working state, the process proceeds to step S26. It is determined whether the devices are completely checked in step S26, step S28, and other steps, and the devices are detected one by one, wherein the detection step S27 can be performed according to the process shown in, for example, FIG. 5.

During check of the first device, in step S271, output current or output power data of the power source before a working state of the device is changed is recorded, wherein the controller can acquire the output current or output power of the power source also via, for example, the LIN network. In S272, the controller 2 changes a working state of the first device 5 by using the first control unit 51, for example, turns off the first device 5 or changes the power of the first device 5. When the first device 5 is a fan motor, the rotational speed of the first device 5 can be changed. In step S273, the output current or output power of the power source after the working state is changed is recorded. In step S274, the output currents or output powers of the power source before and after the working state of the first device is changed are compared, so as to determine whether an anomaly exists in the first device. In some embodiments, it is determined whether an anomaly exists in the motor based on a difference or ratio between the output currents or output powers of the power source before and after the working state of the motor is changed. In a normal case, after the working state of the first device is changed, the output current or output power of the power source will be changed significantly, and a difference will exist between the output currents or output powers of the power source before and after the working state of the motor is changed, that is, their difference will be greater than a predetermined value. However, when their difference is basically zero or is less than a predetermined value, it can be considered that an anomaly has occurred in the first device, that is, the first fuse protection apparatus 52 may be already fused such that the first device is disconnected. In some embodiments, the output currents or output powers of the power source before and after the working state of the first device is changed can further be processed based on another mathematical method, so as to obtain a reference standard and determine whether an anomaly exists in the first device. When the first device has an anomaly, the process proceeds to step S31, to raise a first device anomaly alarm and mark that the first device has been detected, and returns to step S24. If the first device does not have any anomaly, the process proceeds to step S275 to mark that the first device has been detected, returns to step S24, and enters a step for detection of a next device.

In some embodiments, the controller 2 is set to detect all the devices in the refrigeration system one by one. In some other embodiments, the controller 2 can merely detect some devices. For example, when the first device 5 and the second device 6 are condenser fan motors, and the third device 7 and the fourth device 8 are evaporator fan motors, the above detection step can be performed merely on the first device 5 and the second device 6. When the initial detection prompts that an anomaly exists in the system but the performed fine detection step prompts that the first device 5 and the second device 6 do not have any anomaly, the evaporator fan motors will not be detected one by one, and an evaporator fan anomaly alarm is sent directly.

It should be understood that, in the embodiment of FIG. 5, the working state of the first device 5 is changed merely once in step S272, and in an optional embodiment, the working state of the first device 5 can be changed multiple times, for example, twice or three times, so as to determine more accurately whether an anomaly exists in the first device 5. For example, the following steps can be performed: recording output current or output power data of the power source; the controller 2 turning off the first device 5 by using the first control unit 51; recording the output current or output power data of the power source for the second time; the controller 2 turning on the first device 5 by using the first device 51; and recording the output current or output power data of the power source for the third time. Therefore, three groups of output current or output power data of the power source before and after the working state of the device is changed twice can be obtained. In some embodiments, determination can be performed based on the first two groups of data, and re-check is performed based on the last two groups of data. In some other embodiments, whether an anomaly exists in the first device can be determined based on the three groups of data. For example, in some embodiments, it can be determined whether an anomaly exists in the first device based on a mean variance of the three groups of data.

According to another aspect of the present invention, the present invention further provides a refrigeration system which includes a controller having a fault detection system, which performs the fault detection method according to the various embodiments of the present invention.

The specific embodiments described above are merely used for describing the principles of the present invention more clearly, wherein components are clearly shown or described such that the principles of the present invention are more comprehensible. Those skilled in the art can easily make various modifications or changes to the present invention without departing from the scope of the present invention, which is defined by the claims.

## Claims

1. A fault detection method for a refrigeration system, comprising:
an initial detection step, wherein the initial detection step comprises:
acquiring an output current or output power of a power source (1) when system parameters are stable; and when the system parameters are unstable, re-determining whether the system parameters are stable after a delay of first predetermined time;
calculating a theoretical output current or output power of the power source;
comparing the output current or output power of the power source with the theoretical output current or output power of the power source to determine whether an anomaly exists in the system; and
marking a system anomaly if an anomaly exists in the system; and
a fine detection step, wherein the fine detection step comprises:
determining whether there is a system anomaly mark, wherein if there is no system anomaly mark, the method returns to the initial detection step;
re-determining whether the system parameters are stable, wherein if the system parameters are unstable the fine detection step is started again after a delay of a certain time; and
changing a working state of at least one device (5, 6, 7, 8), and comparing the output currents or output powers of the power source (1) before and after the working state of the at least one device is changed, so as to determine whether an anomaly exists in the at least one device.

2. The method according to claim 1, wherein the method further comprises determining whether an anomaly exists in the system based on a difference or ratio between the output current or output power of the power source (1) and the theoretical output current or output power of the power source.

3. The method according to claim 1 or 2, wherein the method further comprises determining whether an anomaly exists in the device based on a difference or ratio between the output currents or output powers of the power source (1) before and after the working state of the device is changed.

4. The method according to any of claims 1, 2, or 3, wherein the method further comprises changing a working state of each of the devices (5, 6, 7, 8) one by one when an anomaly exists in the system, to determine whether an anomaly exists in each of the devices one by one.

5. The method according to any of claims 1 to 4, wherein the changing the working state of the device (5, 6, 7, 8) comprises turning on or turning off the at least one device.

6. The method according to any of claims 1 to 5, wherein the changing the working state of the device (5, 6, 7, 8) comprises reducing or increasing the rotational speed of the at least one device.

7. The method according to any of claims 1 to 6, wherein the method comprises acquiring an excitation current of the power source (1) by communicating with the power source via an LIN network, and reckoning the output current or output power of the power source based on the excitation current.

8. The method according to any of claims 1 to 7, wherein the method further comprises determining whether a current state of the system meets a change condition before a working state of at least one device (5, 6, 7, 8) is changed; and when the current state of the system does not meet the change condition, re-determining whether the current state of the system meets the change condition after a delay of second predetermined time.

9. The method according to any of claims 1 to 8, wherein the method further comprises determining whether the system is currently in a defrosting mode before a working state of at least one device (5, 6, 7, 8) is changed.

10. The method according to any of claims 1 to 9, wherein the method comprises changing a working state of the same device (5, 6, 7, 8) several times.

11. A refrigeration system, especially a transport refrigeration system, comprising:
a power source (1);
a plurality of devices (5, 6, 7, 8) electrically connected in parallel to the power source, a control unit (51, 61, 71, 81) being disposed on a branch of each of the devices; and
a controller (2) that is capable of acquiring an output current or output power of the power source and is in a control connection with the control unit of each of the devices;
wherein the controller comprises a fault detection system for a refrigeration system, wherein the fault detection system is configured to perform the method according to any of claims 1 to 10.

12. The refrigeration system according to claim 11, wherein the control unit (51, 61, 71, 81) of each of the devices is a relay, and the controller (2) is configured to control on/off of each of the devices by using the relay.

13. The refrigeration system according to claim 11, wherein the control unit (51, 61, 71, 81) of each of the devices is a control circuit board, and the controller (2) is configured to control the rotational speed of each of the devices by using the control circuit board.

## Patentansprüche

1. Fehlerdetektionsverfahren für ein Kühlsystem, das Folgendes umfasst:
einen Anfangsdetektionsschritt, wobei der Anfangsdetektionsschritt Folgendes umfasst:
Erhalten eines Ausgangsstroms oder einer Ausgangsleistung einer Leistungsquelle (1), wenn Systemparameter stabil sind; und wenn die Systemparameter instabil sind, erneutes Bestimmen, ob die Systemparameter nach einer Wartezeit für eine erste vorbestimmte Zeitdauer stabil sind;
Berechnen eines theoretischen Ausgangsstroms oder einer theoretischen Ausgangsleistung der Leistungsquelle;
Vergleichen des Ausgangsstroms oder der Ausgangsleistung der Leistungsquelle mit dem theoretischen Ausgangsstrom oder der theoretischen Ausgangsleistung der Leistungsquelle, um zu bestimmen, ob eine Anomalie in dem System vorhanden ist; und
Markieren einer Systemanomalie, wenn eine Anomalie in dem System vorhanden ist; und
einen Feindetektionsschritt, wobei der Feindetektionsschritt Folgendes umfasst:
Bestimmen, ob eine Systemanomalie-Markierung vorliegt, wobei, wenn keine Systemanomalie-Markierung vorliegt, das Verfahren zu dem Anfangsdetektionsschritt zurückkehrt;
erneutes Bestimmen, ob die Systemparameter stabil sind, wobei, wenn die Systemparameter instabil sind, der Feindetektionsschritt nach einer Wartezeit für eine bestimmte Zeitdauer nochmals gestartet wird; und
Ändern eines Arbeitszustands mindestens einer Vorrichtung (5, 6, 7, 8) und Vergleichen der Ausgangsströme oder der Ausgangsleistungen der Leistungsquelle (1) bevor und nachdem der Arbeitszustand der mindestens einen Vorrichtung geändert wird, um zu bestimmen, ob eine Anomalie in der mindestens einen Vorrichtung vorhanden ist.

2. Verfahren nach Anspruch 1, wobei das Verfahren ferner Bestimmen, ob eine Anomalie in dem System vorhanden ist, basierend auf einer Differenz oder einem Verhältnis zwischen dem Ausgangsstrom oder der Ausgangsleistung der Leistungsquelle (1) und dem theoretischen Ausgangsstrom oder der theoretischen Ausgangsleistung der Leistungsquelle umfasst.

3. Verfahren nach Anspruch 1 oder 2, wobei das Verfahren ferner Bestimmen, ob eine Anomalie in der Vorrichtung vorhanden ist, basierend auf einer Differenz oder einem Verhältnis zwischen den Ausgangsströmen oder den Ausgangsleistungen der Leistungsquelle (1) bevor und nachdem der Arbeitszustand der Vorrichtung geändert wird, umfasst.

4. Verfahren nach einem der Ansprüche 1, 2 oder 3, wobei das Verfahren ferner einzelnes Ändern eines Arbeitszustands jeder der Vorrichtungen (5, 6, 7, 8) umfasst, wenn eine Anomalie in dem System vorhanden ist, um einzeln zu bestimmen, ob eine Anomalie in jeder der Vorrichtungen vorhanden ist.

5. Verfahren nach einem der Ansprüche 1 bis 4, wobei das Ändern des Arbeitszustands der Vorrichtung (5, 6, 7, 8) ein Ein- oder Ausschalten der mindestens einen Vorrichtung umfasst.

6. Verfahren nach einem der Ansprüche 1 bis 5, wobei das Ändern des Arbeitszustands der Vorrichtung (5, 6, 7, 8) Reduzieren oder Erhöhen der Drehzahl der mindestens einen Vorrichtung umfasst.

7. Verfahren nach einem der Ansprüche 1 bis 6, wobei das Verfahren Erhalten eines Erregerstroms der Leistungsquelle (1) durch Kommunizieren mit der Leistungsquelle über ein LIN-Netzwerk und Abrechnen des Ausgangsstroms oder der Ausgangsleistung der Leistungsquelle basierend auf dem Erregerstrom umfasst.

8. Verfahren nach einem der Ansprüche 1 bis 7, wobei das Verfahren ferner Bestimmen, ob ein aktueller Zustand des Systems eine Änderungsbedingung erfüllt, bevor ein Arbeitszustand mindestens einer Vorrichtung (5, 6, 7, 8) geändert wird; und, wenn der aktuelle Zustand des Systems die Änderungsbedingung nicht erfüllt, erneutes Bestimmen, ob der aktuelle Zustand des Systems die Änderungsbedingung nach einer Wartezeit für eine zweite vorbestimmte Zeitdauer erfüllt, umfasst.

9. Verfahren nach einem der Ansprüche 1 bis 8, wobei das Verfahren ferner Bestimmen, ob sich das System aktuell in einem Enteisungsmodus befindet, bevor ein Arbeitszustand mindestens einer Vorrichtung (5, 6, 7, 8) geändert wird, umfasst.

10. Verfahren nach einem der Ansprüche 1 bis 9, wobei das Verfahren mehrmaliges Ändern eines Arbeitszustands derselben Vorrichtung (5, 6, 7, 8) umfasst.

11. Kühlsystem, insbesondere ein Transportkühlsystem, das Folgendes umfasst:
eine Leistungsquelle (1);
eine Vielzahl von Vorrichtungen (5, 6, 7, 8), die elektrisch in Reihe mit der Leistungsquelle geschaltet ist, wobei an einem Zweig jeder der Vorrichtungen eine Steuereinheit (51, 61, 71, 81) angeordnet ist; und
eine Steuerung (2), die in der Lage ist, einen Ausgangsstrom oder eine Ausgangsleistung der Leistungsquelle zu erhalten, und in einer Steuerverbindung mit der Steuereinheit jeder der Vorrichtungen steht;
wobei die Steuerung ein Fehlerdetektionssystem für ein Kühlsystem umfasst, wobei das Fehlerdetektionssystem dazu konfiguriert ist, das Verfahren nach einem der Ansprüche 1 bis 10 auszuführen.

12. Kühlsystem nach Anspruch 11, wobei die Steuereinheit (51, 61, 71, 81) jeder der Vorrichtungen ein Relais ist und die Steuerung (2) dazu konfiguriert ist, Ein/Aus jeder der Vorrichtungen unter Verwendung des Relais zu steuern.

13. Kühlsystem nach Anspruch 11, wobei die Steuereinheit (51, 61, 71, 81) jeder der Vorrichtungen eine Steuerungsplatine ist und die Steuerung (2) dazu konfiguriert ist, die Drehzahl jeder der Vorrichtungen unter Verwendung der Steuerungsplatine zu steuern.

## Revendications

1. Procédé de détection de défaut pour un système de réfrigération, comprenant :
une étape de détection initiale, dans lequel l'étape de détection initiale comprend :
l'acquisition d'un courant de sortie ou d'une puissance de sortie d'une source d'alimentation (1) lorsque des paramètres de système sont stables ; et lorsque les paramètres de système sont instables, le fait de déterminer à nouveau si les paramètres de système sont stables après un délai d'un premier temps prédéterminé ;
le calcul d'un courant de sortie ou d'une puissance de sortie théorique de la source d'alimentation ;
la comparaison du courant de sortie ou de la puissance de sortie de la source d'alimentation avec le courant de sortie ou la puissance de sortie théorique de la source d'alimentation pour déterminer s'il existe une anomalie dans le système ; et
le marquage d'une anomalie de système si une anomalie existe dans le système ; et
une étape de détection fine, dans lequel l'étape de détection fine comprend :
le fait de déterminer s'il existe un repère d'anomalie système, dans lequel en l'absence de repère d'anomalie système, le procédé revient à l'étape de détection initiale ;
le fait de déterminer à nouveau si les paramètres de système sont stables, dans lequel si les paramètres de système sont instables l'étape de détection fine est recommencée après un certain délai ; et
la modification de l'état de fonctionnement d'au moins un dispositif (5, 6, 7, 8), et la comparaison des courants de sortie ou des puissances de sortie de la source d'alimentation (1) avant et après le changement d'état de fonctionnement de l'au moins un dispositif, de manière à déterminer s'il existe une anomalie dans l'au moins un dispositif.

2. Procédé selon la revendication 1, dans lequel le procédé comprend en outre le fait de déterminer s'il existe une anomalie dans le système sur la base d'une différence ou d'un rapport entre le courant de sortie ou la puissance de sortie de la source d'alimentation (1) et le courant de sortie ou la puissance de sortie théorique de la source d'alimentation.

3. Procédé selon la revendication 1 ou 2, dans lequel le procédé comprend en outre le fait de déterminer s'il existe une anomalie dans le dispositif sur la base d'une différence ou d'un rapport entre les courants de sortie ou puissances de sortie de la source d'alimentation (1) avant et après le changement d'état de fonctionnement du dispositif.

4. Procédé selon l'une quelconque des revendications 1, 2 ou 3, dans lequel le procédé comprend en outre la modification d'un état de fonctionnement de chacun des dispositifs (5, 6, 7, 8) un par un lorsqu'une anomalie existe dans le système, pour déterminer si une anomalie existe dans chacun des dispositifs un par un.

5. Procédé selon l'une quelconque des revendications 1 à 4, dans lequel la modification de l'état de fonctionnement du dispositif (5, 6, 7, 8) comprend la mise en marche ou l'arrêt de l'au moins un dispositif.

6. Procédé selon l'une quelconque des revendications 1 à 5, dans lequel la modification de l'état de fonctionnement du dispositif (5, 6, 7, 8) comprend la réduction ou l'augmentation de la vitesse de rotation de l'au moins un dispositif.

7. Procédé selon l'une quelconque des revendications 1 à 6, dans lequel le procédé comprend l'acquisition d'un courant d'excitation de la source d'alimentation (1) par communication avec la source d'alimentation via un réseau LIN, et le calcul du courant de sortie ou de la puissance de sortie de la source d'alimentation sur la base du courant d'excitation.

8. Procédé selon l'une quelconque des revendications 1 à 7, dans lequel le procédé comprend en outre le fait de déterminer si un état actuel du système satisfait une condition de changement avant qu'un état de fonctionnement d'au moins un dispositif (5, 6, 7, 8) soit changé ; et lorsque l'état actuel du système ne satisfait pas la condition de changement, le fait de déterminer à nouveau si l'état actuel du système satisfait la condition de changement après un délai d'un second temps prédéterminé.

9. Procédé selon l'une quelconque des revendications 1 à 8, dans lequel le procédé comprend en outre le fait de déterminer si le système est actuellement en mode dégivrage avant qu'un état de fonctionnement d'au moins un dispositif (5, 6, 7, 8) ne soit changé.

10. Procédé selon l'une quelconque des revendications 1 à 9, dans lequel le procédé comprend la modification à plusieurs reprises d'un état de fonctionnement du même dispositif (5, 6, 7, 8).

11. Système de réfrigération, notamment un système de réfrigération de transport, comprenant :
une source d'alimentation (1) ;
une pluralité de dispositifs (5, 6, 7, 8) connectés électriquement en parallèle à la source d'alimentation, une unité de commande (51, 61, 71, 81) étant disposée sur une branche de chacun des dispositifs ; et
un dispositif de commande (2) qui est capable d'acquérir un courant de sortie ou une puissance de sortie de la source d'alimentation et est dans une connexion de commande avec l'unité de commande de chacun des dispositifs ;
dans lequel le dispositif de commande comprend un système de détection de défaut pour un système de réfrigération, dans lequel le système de détection de défaut est configuré pour exécuter le procédé selon l'une quelconque des revendications 1 à 10.

12. Système de réfrigération selon la revendication 11, dans lequel l'unité de commande (51, 61, 71, 81) de chacun des dispositifs est un relais, et le dispositif de commande (2) est configuré pour commander la mise en marche/l'arrêt de chacun des dispositifs à l'aide du relais.

13. Système de réfrigération selon la revendication 11, dans lequel l'unité de commande (51, 61, 71, 81) de chacun des dispositifs est une carte de circuit de commande, et le dispositif de commande (2) est configuré pour commander la vitesse de rotation de chacun des dispositifs à l'aide de la carte de circuit de commande.
